# EUROPEAN PATENT SPECIFICATION

(11) **EP 1 197 968 B1**
(45) Date of publication and mention of the grant of the patent: **07.03.2007**
(21) Application number: 00830620.1
(22) Date of filing: 18.09.2000
(51) Int. Cl.: G11C 11/56, G11C 16/10, G11C 16/32

(54) **Method and circuit for programming a multibit non-volatile memory with a reduced number of pins**
Verfahren und Schaltung zur Programmierung eines nichtflüchtigen Multibitspeichers mit einer reduzierten Anzahl von Kontaktstiften
Procédé et circuit pour la programmation d'une mémoire multibit non volatile avec un nombre réduit de broches de contact

(43) Date of publication of application: 17.04.2002
(73) Proprietor: STMicroelectronics S.r.l., 20041 Agrate Brianza (Milano) (IT)
(72) Inventor: Rolandi, Paolo, 27058 Voghera (Pavia) (IT); Montanaro, Massimo, 27100 Pavia (IT); Oddone, Giorgio, 16010 Rossiglione (Genova) (IT)
(74) Representative: Modiano, Micaela Nadia

(56) References cited:
- FR-A- 2 632 110
- PATENT ABSTRACTS OF JAPAN vol. 1995, no. 03, 28 April 1995 (1995-04-28) & JP 06 348866 A (MATSUSHITA ELECTRON CORP), 22 December 1994 (1994-12-22)

## Description

The present invention relates to a method and a circuit for programming a multilevel non-volatile memory.

It is known that the most recent developments in the field of non-volatile memories, particularly EPROM and FLASH memories, are directed toward increasing their storage capacity.

Architectures of the multilevel type currently seem to be the most promising for this goal. However, reading these memories, and even more so writing to them, requires the use of highly sophisticated techniques. It is also known to the experts in the field that the method normally used to program a multilevel cell is a so-called "voltage ladder" generated entirely inside the memory device. Moreover, in order to achieve effective programming, pins dedicated expressly to this operation are used, thus limiting the future expansion of the memory, which requires an ever-increasing number of address pins.

Additionally, conventional memories use, as a synchronization signal for the programming operation, a pin, known as Cen (chip enable) which however in some memory devices may not be available (for example MASK ROMs with a capacity of 64 Mbit or more).

Moreover, the duration of the elementary pulse for programming the individual memory cells is normally set by means of complicated internal clock circuits, whose delay is notoriously process-dependent and varies among individual devices.

FR-A-2 632 110 discloses a method of programming a non-volatile memory with a reduced number of pins.

The aim of the present invention is to provide a method for programming a multilevel non-volatile memory which allows to perform writing (programming) without resorting to expressly dedicated write pins.

Within this aim, an object of the present invention is to provide a method for programming a multilevel non-volatile memory which does not require internal clock generation circuits to generate adapted synchronization signals used for programming.

Another object of the present invention is to provide a circuit for programming a multilevel non-volatile memory which allows to implement the method according to the invention.

Another object of the present invention is to provide a method and a circuit for programming a multilevel non-volatile memory which allow, with a minimal increase in overall dimensions and logical complexity, to program a multilevel memory cell.

Another object of the present invention is to provide a method and a circuit for programming a multilevel non-volatile memory which are highly reliable, relatively simple to provide and at competitive costs.

This aim and these and other objects which will become better apparent hereinafter are achieved by a method for programming a multilevel non-volatile memory with a reduced number of pins, as defined in claim 1.

This aim and these objects are also achieved by a circuit for programming a multilevel memory as defined in claim 6.

Further characteristics and advantages of the invention will become better apparent from the description of a preferred but not exclusive embodiment of the method and the circuit according to the invention, illustrated only by way of non-limitative example in the accompanying drawings, wherein:
Figure 1 is a flowchart of the steps of the programming method according to the present invention;
Figures 2a and 2b are, respectively, timing charts of external and internal signals of the memory device to which the method according to the present invention is applied;
Figure 3 is a block diagram of an architecture of a data bus and a verify circuit used to implement the method according to the invention; and
Figure 4 is a block diagram of a programming circuit used to implement the method according to the present invention.

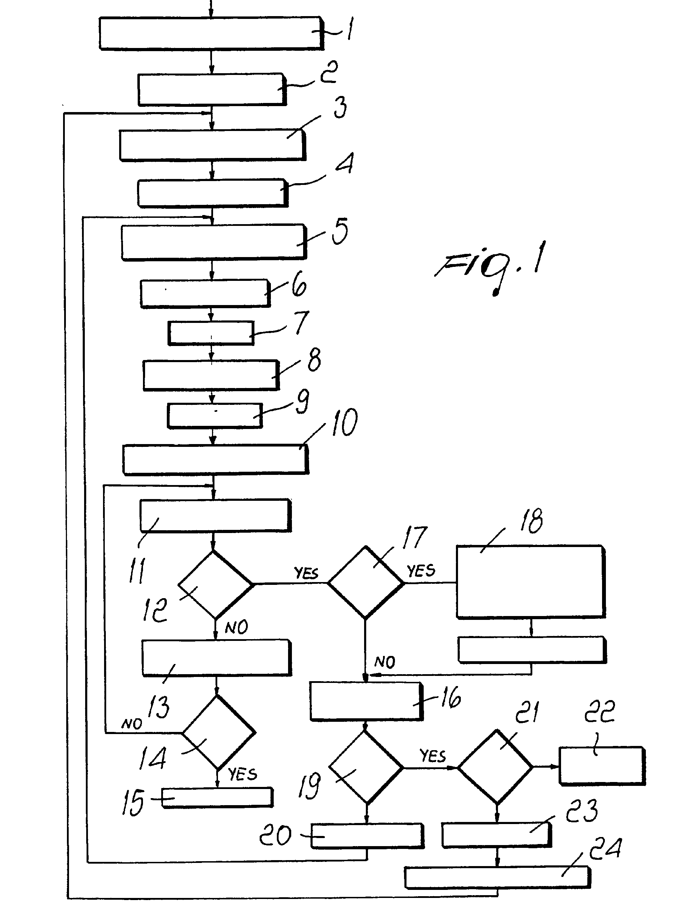

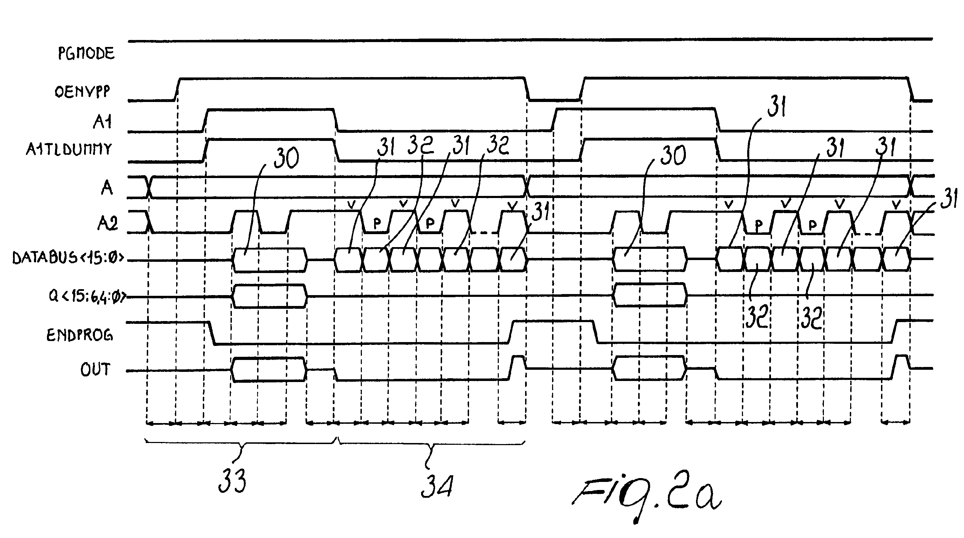

With reference to the figures, wherein identical numerals and reference signs correspond to identical elements, the programming method according to the present invention is shown schematically in the flowchart of Figure 1.

The basic concept of the present invention is the implementation of an effective method for electrically programming the multilevel non-volatile memory by means of a circuit which uses one or more address pins as a write synchronization signal. By means of these address pins, the duration of the programming of the cell is also set without resorting to complicated internal clock circuits, whose delay is notoriously process-dependent and varies among individual devices.

The method used for multilevel non-volatile memory writing by using one or more address pins for synchronization is shown in the flowchart of Figure 1. The case in which the programming levels involved are four, i.e., two bits for each individual memory cell, is considered by way of example. This is of course merely an example and must not be considered as a limitation.

The first step of the method according to the invention, designated by the reference numeral 1 in Figure 1, comprises setting the memory programming mode, which is activated, as is known for some memories, by a signal PGMODE which arrives from the output of a latch, in which the active state is determined by a particular address of the memory which is brought to the "1" level. This is intended to circuitally isolate the programming mode from the remaining operating mode of the memory.

The method according to the invention uses at least one and preferably two or more write/verify synchronization addresses chosen among the address pins.

If two synchronization addresses are used, writing an entire array requires four consecutive steps. Programming of a first quarter of the array begins by setting all the addresses to zero, step 2, and then bringing the pin of the supply voltage Vpp to a high voltage level, step 3, for example to approximately 12 V, in order to store, on the rising front, the value of the two addresses used for synchronization, which at this point become free.

The step for storing the two addresses is designated by the reference numeral 4.

In step 5, the first synchronization address is brought to the "1" level, and together with the high-voltage supply voltage Vpp, a signal A1TLDUMMY is generated and an internal counter is reset on its rising front, step 6; said counter stores the number of programming pulses sent by a ladder voltage source on the gate terminal of the memory cell to be programmed.

The hardware configuration used to implement the method according to the invention is described in greater detail hereinafter, so as to clarify the various components and their function.

The second free address, step 7, is varied so that the data to be programmed, which arrive from the data inputs of the memory are latched on its falling front, step 8.

This pre-programming step ends by bringing to the "1" level the second synchronization address, which from here onward acts as a clock, and by bringing to the zero level, step 9, the first synchronization address, which brings to the zero level an output OUT which is used as an indicator in order to indicate to the programmer the beginning of the programming step, when it is at the "0" level, and the end of the programming step when it is at the "1" level.

The zero transition of the output OUT is shown in step 10, which is followed by step 11, in which the second address used for synchronization is brought to the "1" level.

The actual programming step begins and ends with a verification, step 12, so that at the beginning it is possible to test the virgin cells rapidly and without subjecting them to stress and at the end in order to change the array address in the absence of the high voltage.

Upon each negative verification, the counter is incremented up to its maximum value, steps 13 and 14, after which the cell that has failed to be programmed is marked as "bad", step 15.

If instead the verification has yielded a positive result, programming ends by forcing to "1" the indicator on the output OUT, step 16. If the programmed value is a "00", step 17, the counter is fully set to "1", step 18, so that the gate terminal of the "00" cell receives the maximum voltage that can ensure a sufficient programming margin.

The programming cycle is repeated, for each quarter of the array, step 19, by incrementing the addresses, step 20, when transition from one quarter of the array to the other is not required.

The address increment returns the method to step 5.

If instead the array quarter has already been programmed, the method moves on to step 21, which verifies whether the current address is the last address for programming; if so, the programming cycle ends, step 22.

Otherwise, high voltage is removed from Vpp, step 23, and then the first and/or second synchronization addresses are changed, step 24, for example bringing the first address to the "1" level and the second address to the "0" level again, and the method restarts by bringing the voltage Vpp to a high value so as to store said addresses again.

In practice, step 24 points to step 3 of the above-described method.

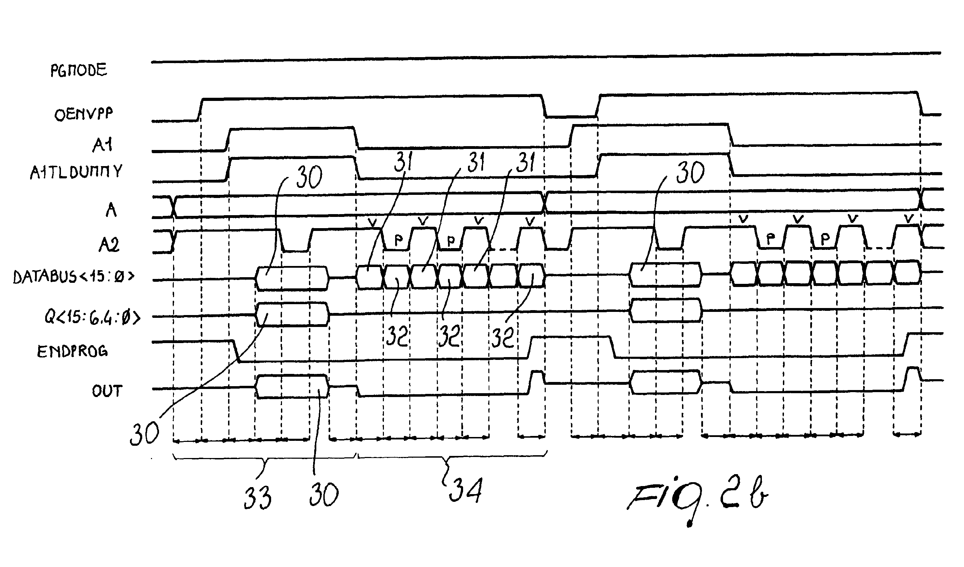

Figures 2a and 2b are flowcharts of the signals involved in the method according to the present invention, and the signal designated by DATABUS, in which the reference numeral 30 designates the loading of data in an address, the reference numeral 31 designates a data acquisition step, the reference numeral 32 designates a data storage step, and so forth, and the reference letters V and P at the second synchronization address A2 respectively indicate verification and programming steps.

The reference numeral 33 in the chart of Figure 2a, as well as in the chart of Figure 2b, and likewise the reference numeral 34, respectively designate the preprogramming and programming steps.

The signal ENDPROG indicates the end of programming and is emitted by the counter which is described in detail hereinafter.

The letter A designates an address transition of all the addresses except for the two used for writing (A1, A2).

The chart of Figure 2b is substantially similar to the chart of Figure 2a, except that the second synchronization address A2 is high and is brought low ("0") upon transit of the data on the data bus DATABUS. This allows to store the data related to the locations of another memory portion with respect to Figure 2a. Substantially, Figure 2a illustrates the writing of data in a first quarter and a second quarter of the memory array, while Figure 2b illustrates the same writing steps for the third and fourth quarters of the memory array.

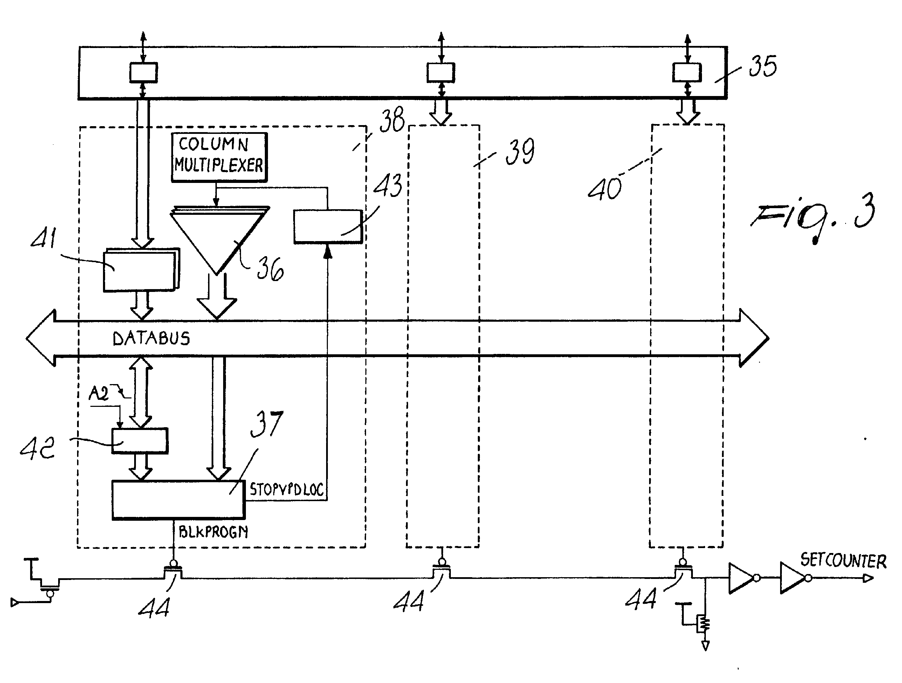

Figure 3 is a block diagram of the data bus DATABUS which is used to store the data item to be programmed, which arrives from the output pads 35 of the memory and then, during the verification step, to transfer the data in output from the sense amplifiers 36 to a comparison logic 37. During the programming step, the stored data item is presented again on the data bus DATABUS so as to prevent the floating nodes from being sources of additional consumption. The memory is divided into a plurality of blocks, one for every two output bits for a four-level memory.

The reference numeral 38 designates the zero block, which is similar to the subsequent blocks 39 and 40.

At the level of each block, the comparison logic 37 compares the data to be programmed with the data in output from the sense amplifiers.

The data to be programmed are input from the output pads 35 through a buffer 41 to the data bus DATABUS and from there to the memory element 42, in which the second address signal used for synchronization is also input.

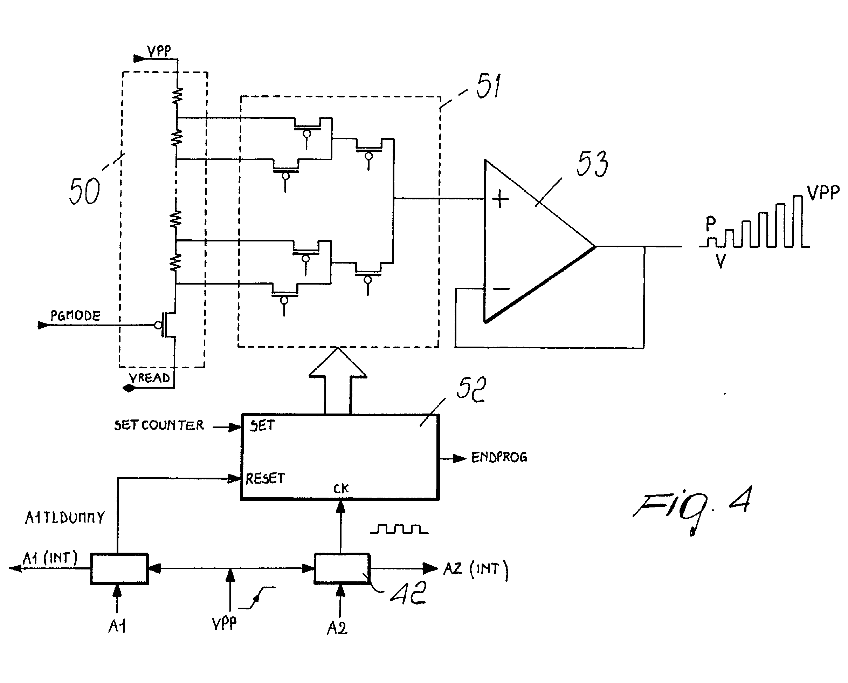

The memory element 42 is connected to the comparison logic 37 which, once programming has occurred, removes the high voltage on the drain terminal of the cell, sending a signal STOPVPDLOC to a local source 43 of the voltage that drives the sense amplifiers 36, and drives, by means of a signal BLKPROGN, a distributed logic, formed by a P-channel MOS transistor 44, for each block 38, 39 and 40, respectively. The distributed logic sets the counter, shown in Figure 4, by means of the signal SETCOUNTER, when all the blocks have been programmed and the last pulse at the highest voltage for the "00" cell remains.

The ladder voltage required to program a multilevel cell is generated, as shown in Figure 4, by taking from a resistive divider 50 between a voltage Vpp and a read voltage VREAD the voltage level that is appropriately selected by means of a decoding logic 51 which is driven by said counter 52, which receives in input the signal SETCOUNTER. The voltage level that is selected by means of the decoding logic 51 is sent to the gate terminal of the cell to be programmed, using as a driver an operational amplifier 53 which is negative feedback-connected.
The modulus of the counter depends on the programming voltage and on the precision of the ladder to be generated. For example, a programming voltage range of 5.5 to 11.5 V and a required precision of 100 mV require 60 pulses and therefore require a 6x counter. The same counter sets to "1" the indicator on the output OUT at the end of programming, emitting the ENDPROG signal.

In practice it has been observed that the method and the circuit for programming a multilevel non-volatile memory with an external synchronization signal fully achieves the intended aim and objects, since it allows, with a minimal increase in overall dimensions and logic complexity, to program a multilevel memory cell by using as a synchronization signal for the entire operation two address pins instead of the CEn pin, which may sometimes be unavailable.

Moreover, the synchronization obtained from the internal/external management of the entire write operation, from the generation of the voltage ladder to the use, for the verification step, of the same circuits used in a normal read cycle, helps to increase the accuracy of the programmed voltage levels.

Where technical features mentioned in any claim are followed by reference signs, those reference signs have been included for the sole purpose of increasing the intelligibility of the claims and accordingly such reference signs do not have any limiting effect on the scope of each element identified by way of example by such reference signs.

## Claims

1. A method for programming a multilevel non-volatile memory with a reduced number of pins, comprising the step of setting (1) said memory in a programming mode, **characterized in that** said non-volatile memory is a multilevel memory and **in that** it further comprises the steps of:
using, as a write and verify clock an address pin (A2) of said memory;
setting (2) to the zero level all the addresses of said memory and bringing (3) to a high voltage programming level (Vpp) the programming voltage pin of said memory;
storing (4) on the rising front of the programming voltage (Vpp) a first address value and a second address value;
using a first address pin (A1) to reset (6) an internal counter of said memory which is adapted to store the number of programming pulses sent by a ladder voltage source to the gate terminal of a memory cell to be programmed;
storing (8), at a first time instant, by means of a second address pin (A2), data to be programmed in said memory, subsequently using said second address pin as a write and verify clock;
performing a program verification step (12) on memory cells of said memory, followed by a step for the actual programming of said memory cells.

2. The method according to claim 1, **characterized in that** if said verification step (12) yields a negative result, said counter is gradually incremented until it reaches its maximum value after which a memory cell that has failed to be programmed is marked as bad.

3. The method according to claim 1, **characterized in that** the step (8) of storing the data to be programmed by using said second address pin (A2) is performed on the falling front of a signal of said second address pin.

4. The method according to claim 3, **characterized in that** after storing said data to be programmed, on the falling front of a signal of said second address pin (A2), said second address pin is used as a write and verify clock.

5. The method according to claim 1, **characterized in that** the duration of the programming of said memory cells is set by said first and second address pins A1, A2).

6. A programming circuit for a multilevel non-volatile memory, comprising:
a data bus (DATABUS);
output pins (35) of said memory which are connected to said data bus;
a data buffer (41) which is connected between said output pads (35) and said data bus (DATABUS);
**characterized in that** it comprises:
at least one sense amplifier (36) which is connected to said data bus and is driven by a ladder voltage source ;
at least one comparison logic (37) which is adapted to make a comparison between data to be programmed into said memory which arrive from said data bus (DATABUS) and data in output from said sense amplifier (36);
storage means (42) being connected between said data bus (DATABUS) and said comparison logic (37), said storage means being driven by an address pin (A2) of said memory used as a write/verify clock and by a further address pin (A1) of said memory used as a reset signal (RESET) for an internal counter of said memory.

7. The circuit according to claim 6, **characterized in that** said comparison logic (37) generates a signal (STOPVPDLOC) indicating a voltage drop for said ladder voltage source and a signal (BLKPROGN) for driving a distributed logic (44) of said memory.

8. The circuit according to claim 6, **characterized in that** said ladder voltage source comprises a voltage divider (50) and a decoding logic (51) which drives a negative-feedback operational amplifier (53), said operational amplifier being connected to the gate terminal of a memory cell to be programmed.

9. The circuit according to claim 8, **characterized in that** said decoding logic (51) is driven by a counter (52) which is adapted to receive in input an output signal (SETCOUNTER) of said distributed logic (44).

10. The circuit according to claim 9, **characterized in that** said storage means which are respectively adapted to store the value of a first address pin (A1) and of a second address pin (A2) and to free said first and second address pins, said second address pin (A2) constituting said write and verify clock and said first address pin(A1), together with a programming voltage, generating said reset signal for said counter (52).

## Patentansprüche

1. Verfahren zum Programmieren eines nichtflüchtigen Multilevel-Speichers mit einer reduzierten Anzahl Pins, mit einem Schritt des Einstellens (1) des Speichers in einen Programmiermodus, **dadurch gekennzeichnet, dass** der nichtflüchtige Speicher ein Multilevel-Speicher ist und dass das Verfahren weiterhin die folgenden Schritte umfasst:
Verwenden eines Adress-Pins (A2) des Speichers als Schreib- und Prüftakt; Einstellen (2) aller Adressen des Speichers auf das Null-Niveau und Versetzen (3) des Programmierspannungs-Pins des Speichers auf ein Programmier-Niveau (Vpp) hoher Spannung;
Speichern (4) eines ersten Adresswertes und eines zweiten Adresswertes auf der ansteigenden Vorderflanke der Programmierspannung (Vpp) und;
Verwenden eines ersten Adress-Pins (A1), um einen internen Zähler des Speichers zurückzusetzen (6), der ausgebildet ist, die Anzahl von Programmierimpulsen zu speichern, die von einer Stufenspannungsquelle an das Gate-Terminal einer zu programmierenden Speicherzelle gesendet wurde;
Speichern (8), zu einem ersten Zeitpunkt, zu programmierender Daten im Speicher mit Hilfe eines zweiten Adress-Pins (A2), wobei nachfolgend der zweite Adress-Pin als Schreib- und Prüftakt verwendet wird;
Durchführen eines Programmier-Überprüfschrittes (12) an Speicherzellen des Speichers, gefolgt von einem Schritt zum tatsächlichen Programmieren der Speicherzellen.

2. Verfahren nach Anspruch 1, **dadurch gekennzeichnet, dass**, wenn der Prüfschritt (12) ein negatives Ergebnis ergibt, der Zähler schrittweise inkrementiert wird, bis er seinen Maximalwert erreicht, wonach eine Speicherzelle, deren Programmierung bis dahin gescheitert ist, als schlecht markiert wird.

3. Verfahren nach Anspruch 1, **dadurch gekennzeichnet, dass** der Schritt (8) des Speicherns der zu programmierenden Daten unter Verwendung des zweiten Adress-Pins (A2) auf der abfallenden Flanke eines Signals des zweiten Adress-Pins durchgeführt wird.

4. Verfahren nach Anspruch 3, **dadurch gekennzeichnet, dass** nach dem Speichern der zu programmierenden Daten auf der abfallenden Flanke eines Signals des zweiten Adress-Pins (A2) der zweite Adress-Pin als Schreib- und Prüftakt verwendet wird.

5. Verfahren nach Anspruch1, **dadurch gekennzeichnet, dass** die Dauer der Programmierung der Speicherzellen von den ersten und zweiten Adress-Pins (A1, A2) eingestellt wird.

6. Programmierschaltung für einen nichtflüchtigen Multilevel-Speicher, umfassend:
einen Datenbus (DATABUS);
Ausgangs-Pins (35) des Speichers, die mit dem Datenbus verbunden sind;
ein Datenpuffer (41), der einerseits mit den Ausgangs-Pins (35) und anderseits mit dem Datenbus (DATABUS) verbunden ist;
**dadurch gekennzeichnet, dass** die Programmierschaltung zusätzlich umfasst:
wenigstens einen Lese-Verstärker (36), der mit dem Datenbus verbunden ist und von einer Stufenspannungsquelle gesteuert wird;
wenigstens eine Vergleichslogik (37), die ausgebildet ist, einen Vergleich zwischen in den Speicher zu programmierenden Daten, die vom Datenbus (DATABUS) her eintreffen, und Daten, die vom Lese-Verstärker (36) ausgegeben wurden, durchzuführen;
Speichermittel (42), die einerseits mit dem Datenbus (DATABUS) und andererseits mit der Vergleichslogik (37) verbunden sind, wobei die Speichermittel von einem Adress-Pin (A2) des Speichers gesteuert werden, der als Schreib-/ Prüftakt verwendet wird, und durch einen weiteren Adress-Pin (A1) des Speichers, der als Rückstell-Signal (RESET) für einen internen Zähler des Speichers verwendet wird.

7. Programmierschaltung nach Anspruch 6, **dadurch gekennzeichnet, dass** die Vergleichslogik (37) ein Signal (STOPVPDLOC), das einen Spannungsabfall der Stufenspannungsquelle anzeigt, und ein Signal (BLKPROGN) zum Steuern einer verteilten Logik (44) des Speichers erzeugt.

8. Programmierschaltung nach Anspruch 6, **dadurch gekennzeichnet, dass** die Stufenspannungsquelle einen Spannungsteiler (50) und eine Dekodierlogik (51) enthält, die einen Operationsverstärker (53) mit negativer Rückkopplung steuert, wobei der Operationsverstärker mit dem Gate-Anschluss einer zu programmierenden Speicherzelle verbunden ist.

9. Programmierschaltung nach Anspruch 8, **dadurch gekennzeichnet, dass** die Dekodierlogik (51) von einem Zähler (52) gesteuert wird, der ausgebildet ist, am Eingang ein Ausgangssignal (SETCOUNTER) der verteilten Logik (44) zu empfangen.

10. Programmierschaltung nach Anspruch 9, **dadurch gekennzeichnet, dass** die Speichermittel jeweils ausgebildet sind, den Wert eines ersten Adress-Pins (A1) und eines zweiten Adress-Pins (A2) zu speichern, und den ersten und zweiten Adress-Pin freizustellen, wobei der zweite Adress-Pin (A2) den Schreib- und Prüftakt bildet, und der erste Adress-Pin (A1) zusammen mit einer Programmierspannung das Rückstell-Signal für den Zähler (52) erzeugt.

## Revendications

1. Procédé de programmation d'une mémoire non volatile à plusieurs niveaux avec un nombre réduit de broches, comprenant l'étape consistant à mettre (1) la mémoire dans un mode de programmation, **caractérisé en ce que** la mémoire non volatile est une mémoire à plusieurs niveaux et **en ce que** le procédé comprend en outre les étapes suivantes:
utiliser, en tant qu'horloge d'écriture et de vérification une broche d'adresse (A2) de la mémoire;
mettre (2) au niveau zéro toutes les adresses de la mémoire et amener (3) à un niveau de programmation à haute tension (Vpp), la broche de tension de programmation de la mémoire ;
mémoriser (4), sur le front montant de la tension de programmation (Vpp), une première valeur d'adresse et une seconde valeur d'adresse ;
utiliser une première broche d'adresse (A1) pour remettre à zéro (6) un compteur interne de la mémoire qui est adapté à mémoriser le nombre d'impulsions de programmation envoyées par une source de tension en échelle vers la borne de grille d'une cellule mémoire à programmer ;
mémoriser (8) à un premier instant, au moyen d'une seconde broche d'adresse (A2), des données à programmer dans la mémoire, en utilisant ensuite la seconde broche d'adresse en tant qu'horloge d'écriture et de vérification ;
réaliser une étape de vérification de programme (12) sur les cellules mémoires de la mémoire puis une étape de programmation effective des cellules mémoire.

2. Procédé selon la revendication 1, **caractérisé en ce que**, si l'étape de vérification (12) conduit à un résultat négatif, le compteur est progressivement incrémenté jusqu'à ce qu'il atteigne une valeur maximum après quoi une cellule mémoire dont la programmation a échoué est marquée comme mauvaise.

3. Procédé selon la revendication 1, **caractérisé en ce que** l'étape (8) de mémorisation des données à programmer en utilisant la seconde broche d'adresse (A2) est réalisée sur le front descendant d'un signal de la seconde broche d'adresse.

4. Procédé selon la revendication 3, **caractérisé en ce que**, après mémorisation des données à programmer, sur le front descendant d'un signal de la seconde broche d'adresse (A2), la seconde broche d'adresse est utilisée comme horloge d'écriture et de vérification.

5. Procédé selon la revendication 1, **caractérisé en ce que** la durée de la programmation des cellules mémoires est fixée par les première et seconde broches d'adresse (A1, A2).

6. Circuit de programmation d'une mémoire non volatile à plusieurs niveaux comprenant :
un bus de données (DATABUS) ;
des broches de sortie (35) de la mémoire qui sont connectées au bus de données ;
un tampon de données (41) connecté entre les plots de sortie (35) et le bus de données (DATABUS) ;
**caractérisé en ce qu'**il comprend :
au moins un amplificateur de lecture (36) qui est connecté au bus de données et est piloté par une source de tension en échelle ;
au moins un circuit logique de comparaison (37) adapté à effectuer une comparaison entre des données à programmer dans la mémoire qui arrivent du bus de données (DATABUS) et des données en sortie de l'amplificateur de lecture (36) ;
un moyen de mémorisation (42) connecté au bus de données (DATABUS) et au circuit logique de comparaison (37), le moyen de mémorisation étant piloté par une broche d'adresse (A2) de la mémoire utilisée comme horloge d'écriture/vérification et par une autre broche d'adresse (A1) de la mémoire utilisée comme signal de remise à zéro (RESET) pour un compteur interne de la mémoire.

7. Circuit selon la revendication 6, **caractérisé en ce que** le circuit logique de comparaison (37) produit un signal (STOPVPDLOC) indiquant une chute de tension à partir de la source de tension en échelle et un signal (BLKPROGN) pour piloter un circuit logique réparti (44) de la mémoire.

8. Circuit selon la revendication 6, **caractérisé en ce que** la source de tension en échelle comprend un diviseur de tension (50) et un circuit logique de décodage (51) qui pilote un amplificateur opérationnel à contre-réaction (53), l'amplificateur opérationnel étant connecté à la borne de grille d'une cellule mémoire à programmer.

9. Circuit selon la revendication 8, **caractérisé en ce que** le circuit logique de décodage (51) est piloté par un compteur (52) qui est adapté à recevoir en entrée le signal de sortie (SETCOUNTER) du circuit logique réparti (44).

10. Circuit selon la revendication 9, **caractérisé en ce que** les moyens de mémorisation sont respectivement adaptés à mémoriser la valeur d'une première broche d'adresse (A1) et d'une seconde broche d'adresse (A2) et à libérer les première et seconde broches d'adresse, la seconde broche d'adresse (A2) constituant l'horloge d'écriture et de vérification et la première broche d'adresse (A1), avec une tension de programmation, produisant le signal de remise à zéro pour le compteur (52).
